# Europäisches Patentamt
# European Patent Office
# Office européen des brevets

(19)

(11) Publication number : **0 154 420**
**B1**

(12)

## EUROPEAN PATENT SPECIFICATION

(45) Date of publication of patent specification :
06.05.87

(51) Int. Cl.⁴ : **H 01 R 23/68**, H 01 R 13/193

(21) Application number : **85300864.7**

(22) Date of filing : **08.02.85**

(54) Card edge connector with flexible film circuitry.

(30) Priority : 21.02.84 US 581635

(43) Date of publication of application :
11.09.85 Bulletin 85/37

(45) Publication of the grant of the patent :
06.05.87 Bulletin 87/19

(84) Designated contracting states :
**AT BE CH DE FR GB IT LI NL SE**

(56) References cited :
WO-A-83 /020 40
DE-A- 2 827 161
US-A- 4 220 389

(73) Proprietor : **AMP INCORPORATED**
**P.O. Box 3608 449 Eisenhower Boulevard**
**Harrisburg Pennsylvania 17105 (US)**

(72) Inventor : **Andrews, Howard Wallace, Jr.**
**1418 East Derry Road**
**Hershey PA 17033 (US)**
Inventor : **Bobb, Clifford Frank**
**R.D. 10, Box 127**
**Carlisle PA 17013 (US)**
Inventor : **Taylor, Attalee Snar**
**R.D. 1, Box 429 G**
**Palmyra PA 17078 (US)**

(74) Representative : **Gray, Robin Oliver et al**
**BARON & WARREN 18 South End Kensington**
**London W8 5BU (GB)**

Jouve, 18, rue St-Denis, 75001 Paris, France

## Description

The use of flexible film, i. e., printed circuitry on thin insulating material such as polyester film, to interconnect daughter cards to mother boards provides a means to achieve extremely high density interconnections. Connectors using such film are known from several patents dating back to the early 1960's. U.S. Patent 3 102 767 is one such disclosure. Subsequently issued patents include U.S. 3 609 463 wherein a spring biased push member is utilized to urge the contacts on a flexible material against an inserted card. In this and other disclosures, e. g., U.S. 3 401 369, the card is inserted against the biased film, i. e., an insertion force is required.

Workers in the field are now conceptualizing and experimenting with including zero insertion force and wipe in connectors of the above types. However there are difficulties associated with this advancement in the art, e. g., flexible film is more readily susceptible to damage, particularly with respect to the circuits printed thereon and mounting the film to the back panel or mother board at one end and to the connector at the other end. Alignment problems which are present in conventional card edge connectors are at least as big if not a bigger problem in these new type connectors.

It is now intended to provide improvements to a card edge connector of the type described in the immediately preceding paragraph. These improvements simplify the aforementioned problems as well as others.

A zero insertion force, card edge connector for interconnecting circuits on a circuit board and on a circuit card by means of circuits on a flexible film where some circuits thereon are attached to circuits on the circuit board and where an edge extends away from the board, characterised by a housing mounted on a circuit board with a circuit card receiving space adjacent thereto, cam support means on the housing, a cam slidably mounted on the support means, first cooperating means on the housing and on the cam for causing the cam to move laterally towards and away from the card receiving space as the cam moves parallel thereto, a cam follower having one surface for receiving an edge of a flexible film and being slidably mounted on the cam with the one surface facing the card receiving space, and second cooperating means on the housing and cam follower to prevent the cam follower from moving parallel to the card receiving space as the cam moves longitudinally but which permits the cam follower to move laterally as the cam moves laterally towards and away from the card receiving space so that circuits on an edge of a flexible film attached to the one surface will engage and disengage circuits on a circuit card in the card receiving space.

For a better understanding of the invention, reference will now be made by way of example to the accompanying drawings in which :

Figure 1 is an isometric, partly sectioned view of the card edge connector of the present invention ;

Figure 2 is an exploded view of one side of the connector of Figure 1 ; and

Figure 3 is a sectional end view of the connector of Figure 1 showing one side open and the other side closed.

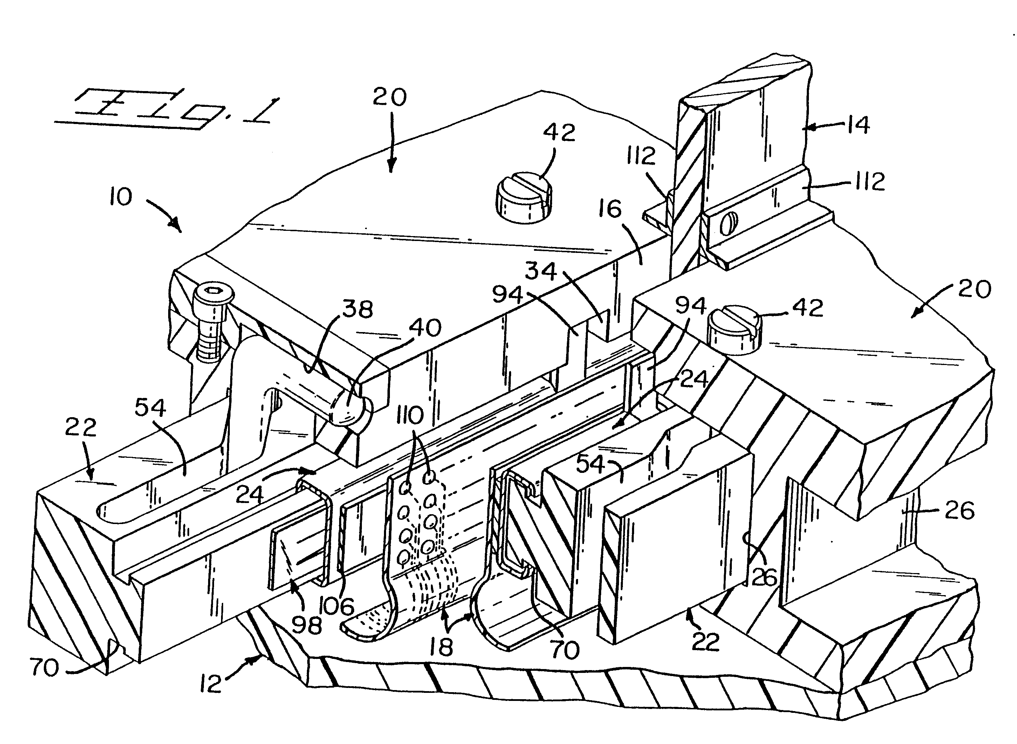

Figure 1 shows a connector 10 mounted on a back panel or mother board 12. The connector receives daughter card 14 in card edge receiving slot 16 and connects the circuitry thereon to the circuitry on the board through printed circuitry on a strip of flexible film 18.

The major components of connector 10 include housing 20, cams 22 and cam followers 24. If the circuitry is on one side only of card 14, connector 10 would include one housing, one cam and one follower (plus certain supporting structures, not shown). The embodiment shown is for cards with circuitry on both sides and accordingly have two housings, two cams and two followers.

Housings 20 are made with a channel 26 running down each side. This design enables one housing to be used for two adjacent connectors.

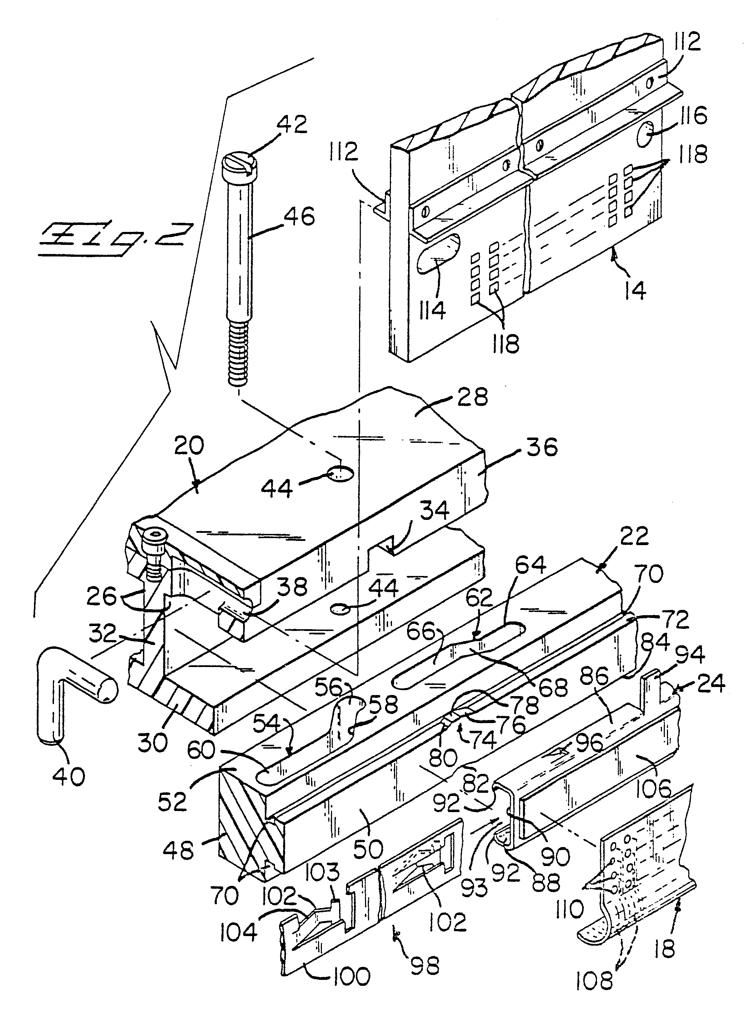

As seen better in Figure 2, the channel defines upper and lower side walls 28 and 30 respectively, and vertical or back wall 32. Notches 34 are provided along the free edge 36 of upper side wall 28. Keying pin recesses 38 (only one is shown) are provided near each end of the upper side wall. The recess opens out onto edge 36 and also into channel 26 with the latter opening being somewhat elongated. The one keying pin 40 shown adjacent the recess in Figure 2 is L-shaped so that one leg extends into the channel when it is positioned in the recess.

Each housing is fastened to the panel or board by bolts 42 which pass through openings 44 in the two side walls and through the channel. These bolts (the number is contingent upon the length of the connector which can be of any desired length) have a shaft or shoulder portion 46 which is long enough to span channel 26.

Housings 20 may be moulded from a suitable plastic or made from metal such as steel. In the latter case, one method of providing recesses 38 is suggested in the drawings, i. e., milling out the recess and capping it.

Cam 22 will now be described with continuing reference to Figure 2. The cam is an elongated, rectangular block 48 with a rail 50 on one side thereof. Two sets of camming slots are provided in the upper surface 52 of the block. One set includes two such slots, one of which is shown and indicated by reference numeral 54. These slots, which receive one leg of pin 40, have a short first parallel section 56, a short oblique section 58, and a long second parallel section 60. These slots are located adjacent each end of the cam.

The second set of cam slots, again only one is shown, is indicated by reference numeral 62.

These slots extend completely through block 52 and receive therethrough bolt 42, i. e., the shoulder portion 46. These slots have a first parallel section 64 which is offset from a second parallel section 66 by oblique section 68. The length of first parallel section 64 is equal to the combined length of sections 56 and 58 of cam slot 54. The reason therefor will be pointed out below.

Rail 50 is thin, rectangular, and connected to the block such as to define upper and lower grooves 70 therebetween. The upper side 72 of the rail is provided with ramps 74. These ramps include a long slope 76, a flat portion 78, and a steep slope 80. Cut-outs or recesses 82, having the identical shape, are provided on the lower side 84 of the rail and in precise alignment with the ramps. The ramps and recesses are spaced along rail 50 as required.

Cam followers 24 may be stamped and formed from steel. The channel-shaped members are formed with upper and lower side walls 86 and 88 respectively and joined by base wall 90. The free ends of each side wall are turned in as indicated by reference numeral 92. The walls define channel 93. Tabs 94 are struck from the upper side wall 86 and bent to extend upwardly. The number and spacing of the tabs correspond to the number of spacing of notches 34 in housing 20. Ramp following fingers 96 are stamped and formed from the upper side wall and are pushed into the channel defined in part by the side walls. Identical fingers (not shown) are provided on the lower side wall 88.

Followers 24 include biasing means 98 which are secured to the inner surface of base wall 90. The preferred means are shown exploded out of the follower in Figure 2 and include an elongate plate 100 with cantilever beams 102 spaced therealong. The beams have ears 103 on the free ends and are bent into a concave-convex shape with the convex surface 104 facing out of the follower. The plates may be secured to the base wall by riveting, adhesive, or other similar conventional means.

An elastomeric pad 106 is secured to the outer surface of base wall 90 as shown.

The preferred flexible film strip 18 for use with connector 10 is one with the circuitry embedded between insulating layers and connected to pads which project out from the surface. Such a film strip is shown in Figure 2 with the embedded circuitry shown as dashed lines and indicated by reference numeral 108. The pads or buttons are indicated by reference numeral 110.

Figure 2 also includes daughter card 14 to show stop members 112 attached thereto and keying holes 114 and 116. The former is elongated while the latter is circular. Circuit pads 118 on the card provide the contact surface for pads 110 on film 18. The board 12 has similar conductive pads as is well known by those skilled in the art.

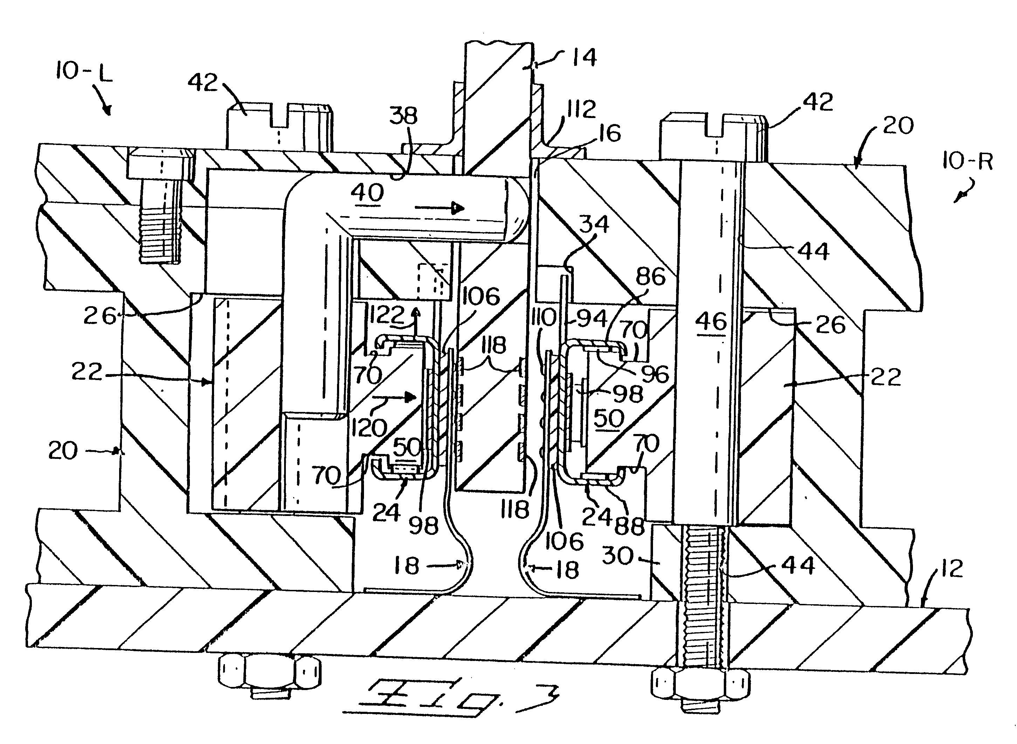

At the present time, the method of assembling connector 10 includes flexible film 18. The circuit pads or circuits themselves on one edge of each of the two film strips are soldered or otherwise secured to board 12. The other edges are secured to the elastomeric pads 106 on followers 24. The cams 22 are assembled to the followers by sliding rails 50 into channels 93. The turned-in free edges of the side walls catch in grooves 70. The housing is added by sliding it onto cam 22, i. e., the cam is received into channel 26. During this step (lower side wall 30 on the housing is supported by the board) tabs 94 enter notches 34 as shown in Figure 1. Bolts 42 are placed in openings 44 and threaded into appropriate receivers on the opposite side of the board. Cam 22 is concurrently captured in channel 26 thereby. Locating pins 40 are placed in the recesses 38 and cam slots 54 and confined by the caps. The connector halves, i. e., one housing with cam, follower and attached film, are spaced apart a distance such that a card can be inserted without engaging films 18. The right-hand connector half, indicated generally by reference numeral 10-R in Figure 3, illustrates this. Stop members 112 automatically limit the insertion depth so that circuit pads 118 on the card are in line with conductive buttons 110 on film 18.

The left-hand connector half, indicated by reference numeral 10-L in Figure 3, shows the film pressed against card pads 118, i. e., the connector half has been closed by sliding cam 22 longitudinally along channel 26. The sequence of events is, first, keying pins 40 are cammed out into keying holes 114 and 116. The pin in the latter hole holds the card against movement in any direction. The pin in the former hole, i. e., hole 114, holds the card against vertical movement but does allow some horizontal growth or shrinkage induced by thermal forces. Due to the structure of cam slots 54 and 62, the keying pins are required in the keying holes in the card before the next event takes place. This insures that the card is held securely. The next event is caused by the interaction of cam slot 62 and bold 42 or, more precisely, shoulder portion 46 thereon. The cam is forced to move in towards the card as indicated by arrow 120. As the buttons 110 on the film must touch pads 118 on the card, the long slope 76 on ramps 74 engage fingers 96 forcing follower 24 upwardly as indicated by arrow 122. This movement provides upward wipe. The cam moves further in, with the follower riding across the top of the ramps. With further longitudinal travel, the short slope 80 on the ramps move past fingers 96 and the beveled recess wall engages the fingers to force the follower down, dragging button 110 with it to provide a back wipe across pads 118. At this point cam 22 has been cammed in to its predetermined distance. Buttons 110 are forced against pads 118 with the predetermined amount of force which preferably is about 80 grams.

Although cam 22 is moving both longitudinally and inwardly, tabs 94 on follower 24 hold it against longitudinal travel while permitting it to move perpendicularly.

Elastomeric pad 106, in addition to providing insulation between the film and follower, providing compensation for variations of card thicknesses and even for thickness differences between adjacent pads 118.

Biasing means 98 provide resiliency against forces attempting to introduce changes in the normal forces pushing the film against the card. Further, the resiliency compensates for variations in thicknesses of the cards. In this regard, as the cam is moving in, the cantilever beams are being pressed in until ears 103 bear against plate 100. The nature of the beams change to beams secured at both ends and require substantially greater pressure than is available to further compress them. Consequently, any relaxation in the cam is taken up by the beam returning towards its original shape and the normal forces at the contacting surfaces (buttons 110 and pads 118) remain constant.

Moving cam 22 longitudinally in the opposite direction reverses the aforementioned steps and the card may be withdrawn freely.

The circuit card and film strips have been referred to and illustrated as having pads or buttons. This description and drawings are not intended to limit the use of the connector disclosed herein to that type of circuitry. The claims appended hereto use the term « circuits ». It is intended that that word be used in the broadest sense so as to include pads, buttons, traces and any other circuitry structure that is suitable for use in the connector described herein.

**Claims**

1. A zero-insertion-force, card edge connector (10) for interconnecting circuits (118) on a circuit board (12) and on a circuit card (14) by means of circuits (108, 110) on a flexible film (18) where some circuits (108, 110) thereon are attached to circuits on the circuit board (12) and where a face extends away from the board, characterised by :

a. a housing (20) for mounting on the circuit board (12) with a card receiving space (16) adjacent thereto, and having cam support means (26) thereon ;

b. an elongate cam (22) slidably mounted on the cam support means (26) for longitudinal travel parallel to the housing (20) and to the card receiving space (16) ;

c. first cooperating means (46, 62) on the housing (20) and on the cam (22) for causing the cam (22) to move laterally towards and away from the card receiving space (16) as the cam (22) moves parallel thereto ;

d. a cam follower (24) having one surface receiving a face of the flexible film (18), the cam follower (24) being mounted on the cam (22) in a sliding relation therewith and with the one surface facing the card receiving space (16) ; and

e. second cooperating means (34, 94) on the housing (20) and on the cam follower (24) to prevent the cam follower (24) from moving parallel to the card receiving space (16) as the cam (22) moves longitudinally but which permits the cam follower (24) to move laterally as the cam (22) moves laterally towards and away from the card receiving space (17) so that circuits (110) on the other face of the flexible film (18) attached to the one surface will engage and disengage circuits (118) on a circuit card (14) positioned in the card receiving space (16).

2. A connector as claimed in claim 1, characterised by :

a. a pair of housings (20) for mounting on a circuit board (12) to define a circuit card slot (16) therebetween ;

b. cam support means (26) on each housing (20).

3. The connector (10) of claim 1 or claim 2, further characterised by including cooperating means (74, 96) on the or each cam (22) and on the or each cam follower (24) for moving the or each cam follower (24) away from the circuit board (12) on which the housing (20) may be mounted as the cam or cams (22) move along the cam support means (26).

4. The connector (10) of claim 3, further characterised by including cooperating means (82, 96) on the or each cam (22) and on the or each cam follower (24) for moving the or each cam follower (24) towards the circuit board (12) on which the housing (20) may be mounted as the cam (22) moves along the cam support means (26).

5. The connector (10) of claim 4, further characterised by including keying means (40) mounted on the housing or one of the housings (20) for engagement with a card (14) in the card receiving space (16) or card slot to locate the card (14) in a predetermined position relative to the or the one housing (20).

6. The connector (10) of claim 5 further characterised by including biasing means (98) positioned between the or each cam (22) and the associated cam follower (24) for resiliently biasing the or each cam follower (24) laterally away from the associated cam (22) and towards the card receiving space or slot (16).

7. The connector (10) of claim 4, characterised in that the or each cam follower (24) includes side walls (86, 88) and a base wall (90) to define a channel (93) and the associated cam (22) includes a rail (50) attached to a side facing the card receiving space (16), the cam follower (24) being slidably mounted on the rail (50) with the outside surface of the base wall (90) providing the one surface for receiving an edge of a flexible film (18).

8. The connector (10) of claim 7, characterised in that the cooperating means on the or each cam (22) and associated cam follower (24) includes fingers (96) on the inside surfaces of the side walls (88, 92) of the follower (24) and a ramp (76) on a top edge (72) of the rail (50) raising the cam follower (24) away from the circuit board (12) and a recess (82) in a bottom edge (84) of the rail (50) for forcing the cam follower (24) towards the circuit board (12).

9. The connector (10) of claim 1 or claim 2, characterised in that the or one of the housing (20) includes a pair of cam support means (26), each being adjacent a card receiving space (16) on opposite sides of the housing (20) to provide a basis for two side-by-side connectors (10) with each connector (10) adapted to interconnect a separate circuit card (14) to the circuit board (12).

10. The connector (10) of claim 6, further characterised by including a resilient pad (106) on the one surface (90) of the or each cam follower (24).

11. The connector (10) of claim 10, characterised in that the biasing means (98) include cantilever beams (102).

12. The connector (10) of claim 11, further characterised by including support means (112) adapted to be attached to the circuit card (14) and supported by the housing or housings (20) when the card (14) to which the support means (112) is attached extends into the card receiving space or slot (16).

13. The connector (10) of claim 1 or claim 2, characterised in that the or each cam support means includes a channel (26) in the housing (20) opening out laterally towards the card receiving space or slot (16).

14. The connector of claim 13, characterised in that the cooperating means on the or each housing (20) and associated cam (22) for causing the cam (22) to move laterally includes a shaft (46) secured in the housing (20) and extending through a vertical slot (62) in the cam (22), said slot (62) having two sections (64, 66) horizontally offset one from the other with both sections (64, 66) being parallel to the card receiving space (16) and a third section (68) extending between and connecting the first two sections (64, 66).

15. The connector (10) of claim 5 and claim 14, taken in combination, characterised in that the keying means include an L-shaped pin (40) with a first leg slidingly supported by the housing (20) and a second leg extending into a keying slot (54) in the cam (22) positioned in the channel (26) in that housing (20), the keying slot (54) including a section (58) extending obliquely to the card slot so that by moving the cam (22) longitudinally in one direction, the pin (40) moves with the first leg entering the card slot (16) to enter a hole (116) located in a circuit card (14) in the card slot (16).

16. The connector (10) of claim 15, characterised in that the cooperating means on each housing (20) and on each cam follower (24) includes a notch (34) in one of the side walls (36) defining the housing channel (26) with the notch (34) opening out toward the card slot (16) and a finger (94) on the cam follower (24) which is received in the notch (34), the side walls thereof preventing the cam follower (24) from moving longitudinally but permitting the cam follower (24) to move laterally towards and away from the card slot (16).

17. The connector (10) of claim 16, characterised in that each cam (22) includes a rail (50) attached to the side facing the card slot (16) and each cam follower (24) being channel-shaped through which the rail (50) slides.

18. The connector (10) of claim 17, further including grooves (70) between the rail (50) and side of the cam (22) and the free edges (92) of the side walls (86, 88) which define the channel (93) of the cam followers (24) being turned inwardly and received in the grooves (70) to slidably attach the cam followers (24) to the rails (50).

19. The connector (10) of claim 5 and claim 14, taken in combination, further characterised by including a second L-shaped pin (40) spaced from the first pin (40) and a second keying slot (58) in the cam (22) to receive a second leg on the second pin (40) and wherein the cross section of the first leg on the second pin (40) is smaller than a second hole (114) in the card (14) to permit some horizontal growth or shrinkage of the card (14) due to thermal forces.

**Patentansprüche**

1. Kartenrandverbinder (10) mit Einführkraft Null zum miteinander Verbinden von Schaltungen (118) auf einer Schaltungsplatte (12) und auf einer Schaltungskarte (14) mittels auf einer flexiblen Folie (18) befindlichen Schaltungen (108, 110), wobei einige der auf der Folie vorhandenen Schaltungen (108, 110) an auf der Schaltungsplatte (12) vorhandenen Schaltungen angebracht sind und wobei sich eine Frontseite von der Platte wegerstreckt, gekennzeichnet durch :

a. ein Gehäuse (20) zur Montage auf der Schaltungsplatte (12), wobei ein Kartenaufnahmeraum (16) an dieses angrenzt und an dem Gehäuse ein Steuerflächenglied-Trageeinrichtung (26) vorgesehen ist ;

b. ein an der Steuerflächenglied-Trageeinrichtung (26) gleitend verschiebbar montiertes längliches Steuerflächenglied (22) zur Ausführung einer Bewegung in Längsrichtung parallel zu dem Gehäuse (20) und zu dem Kartenaufnahmeraum (16) ;

c. eine erste Zusammenwirkeinrichtung (46, 62) an dem Gehäuse (20) und an dem Steuerflächenglied (22) zum Veranlassen des Steuerflächenglieds (22) zu einer Bewegung in seitlicher Richtung auf den Kartenaufnahmeraum (16) zu und von diesem weg, während sich das Steuerflächenglied (22) parallel dazu bewegt ;

d. ein Steuerflächenfolgeglied (24), das eine eine Flachseite der flexiblen Folie (18) aufnehmende Oberfläche aufweist, wobei das Steuerflächenfolgeglied (24) an dem Steuerflächenglied (22) gleitend verschiebbar montiert ist und die genannte eine Oberfläche dem Kartenaufnahmeraum (16) zugewendet ist ; und durch

e. eine zweite Zusammenwirkeinrichtung (34, 94) an dem Gehäuse (20) und an dem Steuerflächenfolgeglied (24) zum Verhindern einer Bewegung des Steuerflächenfolgeglieds (24) parallel zu dem Kartenaufnahmeraum (16), während sich das Steuerflächenglied (22) in Längsrichtung bewegt, wobei die Zusammenwirkeinrichtung (34, 94) jedoch eine Bewegung des Steuerflächenfolgeglieds (24) in seitlicher Richtung gestattet, während sich das Steuerflächenglied (22) in seitlicher Richtung auf der Kartenaufnahmeraum (17) zu und von diesem weg bewegt, so daß Schaltungen (110), die sich auf der anderen Flachseite der an der genannten einen Oberfläche angebrachten flexiblen Folie (18) befinden, an Schaltungen (118) auf einer in dem Kartenaufnahmeraum (16) positionierten Schaltungskarte (14) angreifen sowie sich von diesen lösen.

2. Verbinder nach Anspruch 1, gekennzeichnet durch :

a. ein Paar Gehäuse (20) zur derartigen Montage auf einer Schaltungsplatte (12), daß dazwischen ein Schaltungskartenschlitz (16) definiert ist ;

b. eine Steuerflächenglied-Trageeinrichtung (26) an jedem Gehäuse (20).

3. Verbinder (10) nach Anspruch 1 oder Anspruch 2, dadurch gekennzeichnet, daß er eine Zusammenwirkeinrichtung (74, 96) an dem oder an jedem Steuerflächenglied (22) sowie an dem oder an jedem Steuerflächenfolgeglied (24) aufweist zum Bewegen des oder jedes Steuerflächenfolgeglieds (24) von der Schaltungsplatte (12), auf dem das Gehäuse (20) montierbar ist, weg, während sich das Steuerflächenglied oder die Steuerflächenglieder (22) längs der Steuerflächenglied-Trageeinrichtung (26) bewegen.

4. Verbinder (10) nach Anspruch 3, dadurch gekennzeichnet, daß er eine Zusammenwirkeinrichtung (82, 96) an dem oder an jedem Steuerflächenglied (22) sowie an dem oder jedem Steuerflächenfolgeglied (24) aufweist zum Bewegen des oder jedes Steuerflächenfolgeglieds (24) in Richtung auf die Schaltungsplatte (12), auf dem das Gehäuse (20) montierbar ist, zu, während sich das Steuerflächenglied (22) längs der Steuerflächenglied-Trageeinrichtung (26) bewegt.

5. Verbinder (10) nach Anspruch 4, dadurch gekennzeichnet, daß er eine an dem Gehäuse oder an einem der Gehäuse (20) montierte Schlüsseleinrichtung (40) zum Angreifen an einer in dem Kartenaufnahmeraum (16) oder Kartenschlitz befindlichen Karte (14) zur Festlegung der Karte (14) in einer vorbestimmten Position relativ zu dem oder zu dem einen Gehäuse (20) aufweist.

6. Verbinder (10) nach Anspruch 5, dadurch gekennzeichnet, daß er eine zwischen dem oder jedem Steuerflächenglied (22) und dem zugeordneten Steuerflächenfolgeglied (24) positionierte Vorspanneinrichtung (98) zum federnden Vorspannen des oder jedes Steuerflächenglieds (24) in seitlicher Richtung von dem zugeordneten Steuerflächenglied (22) weg und auf den Kartenaufnahmeraum oder -schlitz (16) zu aufweist.

7. Verbinder (10) nach Anspruch 4, dadurch gekennzeichnet, daß das oder jedes Steuerflächenfolgeglied (24) Seitenwände (86, 88) und eine Basiswand (90) aufweist, um einen Kanal (93) zu definieren, daß das zugeordnete Steuerflächenglied (22) eine Schiene (50) aufweist, die an einer dem Kartenaufnahmeraum (16) zugewandten Seite angebracht ist, und daß das Steuerflächenfolgeglied (24) an der Schiene (50) gleitend verschiebbar derart angebracht ist, daß die außenliegende Fläche der Basiswand (90) die genannte eine Oberfläche zum Aufnehmen eines Randbereichs einer flexiblen Folie (18) schafft.

8. Verbinder (10) nach Anspruch 7, dadurch gekennzeichnet, daß die Zusammenwirkeinrichtung an dem oder jedem Steuerflächenglied (22) und dem zugeordneten Steuerflächenfolgeglied (24) Finger (96) an den innenliegenden Oberflächen der Seitenwände (88, 92) des Folgeglieds (24) sowie eine das Steuerflächenfolgeglied (24) von der Schaltungsplatte (12) weg anhebende Rampe (76) an einer oberen Kante (72) der Schiene (50) sowie eine in einer unteren Kante (84) der Schiene (50) vorgesehene Ausnehmung (82) zum Zwängen des Steuerflächenfolgeglieds (24) in Richtung auf die Schaltungsplatte (12) beinhaltet.

9. Verbinder (10) nach Anspruch 1 oder Anspruch 2, dadurch gekennzeichnet, daß das oder eines der Gehäuse (20) ein Paar Steuerflächenglied-Trageeinrichtungen (26) aufweist, von denen jede an einen Kartenaufnahmeraum (16) auf einander entgegengesetzten Seiten des Gehäuses (20) angrenzt, um eine Basis für zwei Seite angeordnete Verbinder (10) zu schaffen, wobei jeder Verbinder (10) dazu ausgelegt ist, eine separate Schaltungskarte (14) mit der Schaltungsplatte (12) zu verbinden.

10. Verbinder (10) nach Anspruch 6, dadurch gekennzeichnet, daß er ein nachgiebiges Anschlußflächen-Kissen (106) auf der genannten einen Oberfläche (90) des oder jedes Steuerflächenfolgeglieds (24) aufweist.

11. Verbinder (10) nach Anspruch 10, dadurch gekennzeichnet, daß die Vorspanneinrichtung (98) freitragende Arme (102) beinhaltet.

12. Verbinder (10) nach Anspruch 11, dadurch gekennzeichnet, daß er eine Stützeinrichtung (112) beinhaltet, die an der Schaltungskarte (14) anbringbar ist und von dem Gehäuse oder den Gehäusen (20) getragen ist, wenn sich die Karte (14), an der die Stützeinrichtung (112) angebracht ist, in den Kartenaufnahmeraum oder -schlitz (16) hineinerstreckt.

13. Verbinder (10) nach Anspruch 1 oder Anspruch 2, dadurch gekennzeichnet, daß die oder jede Steuerflächenglied-Trageeinrichtung einen Kanal (26) in dem Gehäuse (20) beinhaltet, der sich in seitlicher Richtung nach außen zu dem Kartenaufnahmeraum oder -schlitz (16) öffnet.

14. Verbinder nach Anspruch 13, dadurch gekennzeichnet, daß die an dem oder jedem Gehäuse (20) und dem zugeordneten Steuerflächenglied (22) vorgesehene Zusammenwirkeinrichtung zum Veranlassen des Steuerflächenglieds (22) zu einer Bewegung in seitlicher Richtung einen Schaft (46) beinhaltet, der in dem Gehäuse (20) befestigt ist und sich durch einen senkrechten Schlitz (62) in dem Steuerflächenglied (22) hindurcherstreckt, und daß der Schlitz (62) zwei horizontal zueinander versetzte Abschnitte (64, 66), die beide zu dem Kartenaufnahmeraum (16) parallel sind, sowie einen sich zwischen den ersten beiden Abschnitten (64, 66) erstreckenden und diese miteinander verbindenden dritten Abschnitt (68) aufweist.

15. Verbinder 10 nach Anspruch 5 und Anspruch 14 in Kombination, dadurch gekennzeichnet, daß die Schlüsseleinrichtung einen L-förmigen Stift (40) beinhaltet, wobei ein erster Schenkel von dem Gehäuse (20) gleitend verschiebbar getragen ist und sich ein zweiter Schenkel in einen Schlüsselschlitz (54) in dem Steuerflächenglied (22) hineinerstreckt, das in dem Kanal (26) in diesem Gehäuse (20) positioniert ist, und daß der Schlüsselschlitz (54) einen in bezug auf den Kartenschlitz schräg verlaufenden Abschnitt (58) aufweist, so daß durch Bewegen des Steuerflächenglieds (22) in der einen Längsrichtung der Stift (40) eine Bewegung ausführt, wobei der erste Schenkel in den Kartenschlitz (16) eintritt, um in eine Öffnung (116) einzutreten, die in einer in dem Kartenschlitz (16) befindlichen Schaltungskarte (14) vorhanden ist.

16. Verbinder (10) nach Anspruch 15, dadurch gekennzeichnet, daß die an jedem Gehäuse (20) und an jedem Steuerflächenfolgeglied (24) vorgesehene Zusammenwirkeinrichtung eine Vertiefung (34) in einer der den Gehäusekanal (26) definierenden Seitenwände (36), wobei sich die Vertiefung (34) nach außen in Richtung auf den Kartenschlitz (16) öffnet, sowie einen an dem Steuerflächenfolgeglied (24) vorgesehenen Finger (94) beinhaltet, der in der Vertiefung (34) aufgenommen ist, wobei dessen Seitenwände eine Bewegung des Steuerflächenfolgeglieds (24) in Längsrichtung verhindern, jedoch eine Bewegung des Steuerflächenfolgeglieds (24) in seitlicher Richtung auf den Kartenschlitz (16) zu sowie von diesem weg gestatten.

17. Verbinder (10) nach Anspruch 16, dadurch gekennzeichnet, daß jedes Steuerflächenglied (22) eine an der dem Kartenschlitz (16) zugewandten Seite angebrachte Schiene (50) aufweist und jedes Steuerflächenglied (24) kanalförmig ausgebildet ist, wodurch die Schiene (50) gleitend verschiebbar ist.

18. Verbinder (10) nach Anspruch 17, wobei außerdem Nuten (70) zwischen der Schiene (50) und der Seite des Steuerflächenglieds (22) vorgesehen sind, und wobei die freien Kanten (92) der Seitenwände (86, 88), die den Kanal (93) der Steuerflächenfolgeglieder (24) definieren, nach innen umgebogen sind und in den Nuten (70) derart aufgenommen sind, daß die Steuerflächenfolgeglieder (24) in gleitend verschiebbarer Weise an den Schienen (50) angebracht sind.

19. Verbinder (10) nach Anspruch 5 und Anspruch 14 in Kombination, dadurch gekennzeichnet, daß er einen von dem ersten Stift (40) beabstandeten zweiten L-förmigen Stift (40) sowie einen in dem Steuerflächenglied (22) ausgebildeten zweiten Schlüsselschlitz (58) zur Aufnahme eines zweiten Schenkels des zweiten Stifts (40) beinhaltet, und daß der Querschnitt des ersten Schenkels des zweiten Stifts (40) kleiner als eine zweite Öffnung (114) in der Karte (14) ist, um eine gewisses horizontales Ausdehnen oder Schrumpfen der Karte (14) aufgrund thermischer Kräfte zu gestatten.

**Revendications**

1. Connecteur (10) pour bord de carte, à force d'insertion nulle, pour l'interconnexion de circuits (118) situés sur une plaquette (12) à circuit et sur une carte (14) à circuit au moyen de circuits (108, 110) situés sur un film flexible (18), dont certains circuits (108, 110) sont reliés à des circuits situés sur la plaquette (12) à circuit et dont une face s'étend dans une direction s'éloignant de la plaquette, caractérisé par :

a. un boîtier (20) destiné à être monté sur la plaquette (12) à circuit, auquel est adjacent un espace (16) de réception d'une carte, et portant des moyens (26) de support de came ;

b. une came allongée (22) montée de façon coulissante sur les moyens (26) de support de came afin de se déplacer longitudinalement et parallèlement au boîtier (20) et à l'espace (16) de réception de carte ;

c. des premiers moyens coopérants (46, 62) situés sur le boîtier (20) et sur la came (22) afin de provoquer un déplacement latéral de la came (22) la rapprochant et l'éloignant de l'espace (16) de réception de carte pendant que la came (22) se déplace parallèlement à lui ;

d. un suiveur de came (24) présentant une première surface de réception d'une face du film flexible (18), le suiveur de came (24) étant monté sur la came (22) de façon à pouvoir coulisser par rapport à elle et de façon que la première surface soit tournée vers l'espace (16) de réception de carte ; et

e. des seconds moyens coopérants (34, 94) situés sur le boîtier (20) et sur le suiveur de came (24) afin d'empêcher le suiveur de came (24) de se déplacer parallèlement à l'espace (16) de réception de carte pendant que la came (22) se déplace longitudinalement, mais permettant au suiveur de came (24) de se déplacer latéralement pendant que la came (22) se déplace latéralement pour se rapprocher et s'éloigner de l'espace (17) de réception de carte afin que des circuits (110) situés sur l'autre face du film flexible (18) relié à la première surface, s'enclenchent avec et se dégagent de circuits (118) situés sur une carte à circuit (14) disposée dans l'espace (16) de réception de carte.

2. Connecteur selon la revendication 1, caractérisé par :

a. deux boîtiers (20) destinés à être montés sur une plaquette (12) à circuit afin de définir entre eux une rainure (16) de carte à circuit ;

b. des moyens (26) de support de came situés sur chaque boîtier (20).

3. Connecteur (10) selon la revendication 1 ou la revendication 2, caractérisé en outre en ce qu'il comporte des moyens coopérants (74, 96) situés sur la ou chaque came (22) et sur le ou chaque suiveur de came (24) afin d'éloigner le ou chaque suiveur de came (24) de la plaquette (12) à circuit sur laquelle le boîtier (20) peut être monté pendant que la came ou les cames (22) se déplacent le long des moyens (26) de support de came.

4. Connecteur (10) selon la revendication 3, caractérisé en outre en ce qu'il comporte des moyens coopérants (82, 96) situés sur la ou chaque came (22) et sur le ou chaque suiveur de came (24) afin de déplacer le ou chaque suiveur de came (24) vers la plaquette (12) à circuit sur laquelle le boîtier (20) peut être monté pendant que la came (22) se déplace le long des moyens (26) de support de came.

5. Connecteur (10) selon la revendication 4, caractérisé en outre en ce qu'il comporte des moyens de verrouillage (40) montés sur le boîtier ou l'un des boîtiers (20) afin de s'enclencher avec une carte (14) disposée dans l'espace (16) de réception de came ou dans la rainure de carte pour placer la carte (14) dans une position prédéterminée par rapport au boîtier (20) ou à l'un des boîtiers (20).

6. Connecteur (10) selon la revendication 5, caractérisé en outre en ce qu'il comporte des moyens de rappel (98) disposés entre la ou chaque came (22) et le suiveur de came associé (24) afin de rappeler élastiquement le ou chaque suiveur de came (24) latéralement pour l'éloigner de la came associée (22) et le rapprocher de l'espace ou de la rainure (16) de réception de carte.

7. Connecteur (10) selon la revendication 4, caractérisé en ce que le ou chaque suiveur de came (24) comprend des parois latérales (86, 88) et une paroi de base (90) afin de définir une rainure (93), et la came associée (22) comprend un rail (50) relié à un côté tourné vers l'espace (16) de réception de carte, le suiveur de came (24) étant monté de façon à pouvoir coulisser sur le rail (50), la surface latérale extérieure de la paroi de base (90) constituant la première surface pour la réception d'un bord d'un film flexible (18).

8. Connecteur (10) selon la revendication 7, caractérisé en ce que les moyens coopérants sur la ou chaque came (22) et un suiveur de came associé (24) comprennent des doigts (96) situés sur les surfaces intérieures des parois latérales (88, 92) du suiveur (24) et une rampe (76) située sur un bord supérieur (72) du rail (50) faisant monter le suiveur de came (24) et l'éloignant de la plaquette (12) à circuit, et un évidement (82) ménagé dans un bord inférieur (84) du rail (50) pour diriger à force le suiveur de came (24) vers la plaquette (12) à circuit.

9. Connecteur (10) selon la revendication 1 ou la revendication 2, caractérisé en ce que le boîtier (20) ou l'un des boîtiers (20) comprend une paire de moyens (26) de support de came adjacents chacun à un espace (16) de réception de carte, sur des côtés opposés du boîtier (20), pour constituer une base pour deux connecteurs côte à côte (10), chaque connecteur (10) étant conçu pour interconnecter une carte à circuit séparée (14) à la plaquette à circuit (12).

10. Connecteur (10) selon la revendication 6, caractérisé en outre en ce qu'il comporte une semelle élastique (106) située sur la première surface (90) du ou de chaque suiveur de came (24).

11. Connecteur (10) selon la revendication 10, caractérisé en ce que les moyens de rappel (98) comprennent des lames en porte-à-faux (102).

12. Connecteur (10) selon la revendication 11, caractérisé en outre en ce qu'il comporte des moyens (112) de support conçus pour être reliés à la carte (14) à circuit et supportés par le boîtier ou les boîtiers (20) lorsque la carte (14) à laquelle les moyens (112) de support sont reliés pénètre dans l'espace ou la rainure (16) de réception de carte.

13. Connecteur (10) selon la revendication 1 ou la revendication 2, caractérisé en ce que le ou chaque moyen de support de came comprend une rainure (26) ménagée dans le boîtier (20) et débouchant latéralement vers l'espace ou la rainure (16) de réception de carte.

14. Connecteur selon la revendication 13, caractérisé en ce que les moyens coopérants situés sur le ou chaque boîtier (20) et la came associée (22), pour provoquer un déplacement latéral de la came (22), comprennent un axe (46) fixé dans le boîtier (20) et passant à travers une rainure verticale (62) ménagée dans la came (22), ladite rainure (62) comportant deux tronçons (64, 66) décalés horizontalement l'un par rapport à l'autre, les deux tronçons (64, 66) étant parallèles à l'espace (16) de réception de carte et un troisième tronçon (68) s'étendant entre les deux premiers tronçons (64, 66) qu'il relie.

15. Connecteur (10) selon la revendication 5 et la revendication 14, prises en combinaison, caractérisé en ce que les moyens de verrouillage comprennent une goupille (40) de forme en L dont une première branche est supportée de façon coulissante par le boîtier (20) et dont une seconde branche pénètre dans une rainure (54) de verrouillage dans la came (22) disposée dans la rainure (26) de ce boîtier (20), la rainure (54) de verrouillage comprenant un tronçon (58) s'étendant obliquement vers la rainure de la carte afin que, à la suite d'un mouvement longitudinal de la came (22) dans un premier sens, la goupille (40) se déplace, sa première branche entrant dans la rainure de carte (16) pour pénétrer dans un trou (116) ménagé dans une carte (14) à circuit logée dans la rainure (16) de carte.

16. Connecteur (10) selon la revendication 15, caractérisé en ce que les moyens coopérants situés sur chaque boîtier (20) et sur chaque suiveur de came (24) comprennent une encoche (34) ménagée dans l'une des parois latérales (36) définissant la rainure (26) du boîtier, l'encoche (34) s'ouvrant vers la rainure (16) de came, et un doigt (94) situé sur le suiveur de came (24), qui est reçu dans l'encoche (34) dont les parois latérales empêchent le suiveur de came (34) de se déplacer longitudinalement, mais permettent au suiveur de came (24) de se déplacer latéralement pour se rapprocher et s'éloigner de la rainure (16) de carte.

17. Connecteur (10) selon la revendication 16, caractérisé en ce que chaque came (22) comprend un rail (50) relié au côté tourné vers la rainure (16) de carte, chaque suiveur de came (24) présentant une forme en rainure dans laquelle coulisse le rail (50).

18. Connecteur (10) selon la revendication 17, comprenant en outre des gorges (70) situées entre le rail (50) et le côté de la came (22), les bords libres (92) des parois latérales (86, 88), qui définissent la rainure (93) des suiveurs de came (24), étant tournés vers l'intérieur et reçus dans les gorges (70) pour relier de façon coulissante les suiveurs de came (24) aux rails (50).

19. Connecteur (10) selon la revendication 5 et la revendication 14, prises en combinaison, caractérisé en outre en ce qu'il comporte une seconde goupille (40) de forme en L espacée de la première goupille (40) et une seconde rainure (58) de verrouillage ménagée dans la came (22) afin de recevoir une seconde branche de la seconde goupille (40), et dans lequel la section transversale de la première branche de la seconde goupille (40) est inférieure à celle d'un second trou (114) ménagé dans la carte (14) afin de permettre une certaine croissance ou un certain retrait horizontal de la carte (14) sous l'effet de forces thermiques.

Fig. 1

0 154 420

*Fig.2*

FIG 3

10-R
10-L

12 14 16 18 20 22 24 26 30 34 38 40 42 44 46 50 70 86 88 94 96 98 106 110 112 118 120 122